# EUROPÄISCHE PATENTSCHRIFT

(11) **EP 3 532 855 B1**
(45) Veröffentlichungstag und Bekanntmachung des Hinweises auf die Patenterteilung: **02.09.2020**
(21) Anmeldenummer: 17780091.9
(22) Anmeldetag: 05.10.2017
(51) Int. Cl.: G01R 31/385, B07C 5/344

(54) **BATTERIEGREIFER**
BATTERY GRIPPER
DISPOSITIF DE PRÉHENSION DE BATTERIES

(30) Priorität: 25.10.2016 DE 102016120345
(43) Veröffentlichungstag der Anmeldung: 04.09.2019
(73) Patentinhaber: Schunk GmbH & Co. KG Spann- und Greiftechnik, 74348 Lauffen an Neckar (DE)
(72) Erfinder: BECKER, Ralf, 71672 Marbach (DE); OHLHEISER, Michael, 74927 Eschelbronn (DE); MITSCH, Felix, 74388 Talheim (DE)
(74) Vertreter: DREISS Patentanwälte PartG mbB
(86) Internationale Anmeldenummer: PCT/EP2017/075275
(87) Internationale Veröffentlichungsnummer: WO 2018/077584

(56) Entgegenhaltungen:
- US-A- 4 204 161
- US-A1- 2013 175 206

## Beschreibung

Die Erfindung betrifft einen Batteriegreifer zum Greifen und Verlagern von einzelnen Batteriezellen, mit einem Flanschabschnitt zur Anordnung des Batteriegreifers an einen Roboterarm und mit einer Saugseite aufweisenden Saugeinheit zum Greifen der Batteriezelle. Die Erfindung betrifft auch ein Verfahren zum Greifen und Verlagern von einzelnen Batteriezellen.

Derartige Greifer sind aus dem Stand der Technik bekannt. Die Batterien können dabei insbesondere mittels einer Saugeinheit gehalten und damit gegriffen werden. Die einzelnen Batteriezellen werden vorzugsweise zur Bildung von größeren Einheiten zusammengefasst und beispielsweise innerhalb eines gemeinsamen Gehäuses untergebracht. Vor dem Zusammenfassen und Verbauen der einzelnen Batteriezellen ist es erforderlich, diese unterschiedlichen Prüfungen zuzuführen. Beispielsweise ist der Batteriezellentyp zu prüfen, die vorhandene Isolierung an der Batteriezelle, die Spannung der Batteriezelle, die Größenbeschaffenheit der Batteriezelle, die Temperatur der Batteriezelle und dergleichen. Gemäß dem Stand der Technik ist die zu verbauende Batteriezelle folglich unterschiedlichen Prüfständen zuzuführen. In US 2013 0 175 206 A1 ist eine Pick-and-Place-System offenbart, in dem ein Roboter zu testende Batterien von einer Haltestation zu einer Messstation befördert. Aus US 4 204 161 A ist eine Vorrichtung zur automatisierten Ermittlung von elektrischen Eigenschaften an wiederaufladbaren elektro-chemischen Zellen bekannt.

Der vorliegenden Erfindung liegt die Aufgabe zugrunde, einen Batteriegreifer und ein Verfahren bereitzustellen, bei dem die Montage der Batteriezellen zu größeren Einheiten möglichst zeitsparend und kostengünstig ermöglicht wird.

Diese Aufgabe wird mit einem Batteriegreifer mit den Merkmalen des Patenanspruchs 1 gelöst. Ein solcher Batteriegreifer zeichnet sich folglich dadurch aus, dass eine Hebevorrichtung vorgesehen ist, mit der im Betrieb des Batteriegreifers die Saugseite aus einer Greifposition, in der die Batteriezelle gegriffen wird, relativ zum Flanschabschnitt in eine Messposition verlagerbar ist, in der Prüfungen und/oder Messungen an der gegriffenen Batteriezelle durchführbar sind.

Nach dem Greifen der Batteriezelle wird folglich die Batteriezelle aus der Greifposition relativ zum Flanschabschnitt in eine Messposition verlagert. Die Saugseite samt Batteriezelle kann folglich in zwei unterschiedliche Positionen gebracht werden, zum einen in die Greifposition und zum anderen in die Messposition. Dies hat den Vorteil, dass die Batteriezelle als solche vom Batteriegreifer gegriffen werden kann, ohne dass Prüf- und/oder Messeinheiten den Greifvorgang stören. Dies kann insbesondere dann von Vorteil sein, wenn wenig Greifraum zum Greifen der Batteriezelle um die Batteriezelle herum vorgesehen ist. Dann, nach dem Greifen der Batteriezelle, kann diese in die Messposition verlagert werden. In der Messposition können die erforderlichen Prüfungen und/oder Messungen an der Batterie durchgeführt werden. Besonders vorteilhaft ist, dass diese Prüfungen und/oder Messungen der Batterie unmittelbar nach dem Greifen der Batterie vorgenommen werden können, insbesondere während des Verlagerns der Batteriezelle aus beispielsweise einem Zellenvorrat hin zu beispielsweise einer größeren Batterieeinheit, die sich letztlich aus mehreren einzelnen Batteriezellen zusammensetzt. Dadurch kann das Anfahren unterschiedlicher Prüfstationen entfallen, da mehrere oder auch alle an der Batteriezelle durchzuführende Prüfungen und/oder Messungen im oder am Batteriegreifer erfolgen können. Insgesamt ergibt sich hierdurch ein zeitsparendes und kostengünstiges Handhaben der Batteriezellen.

Die Verlagerung der Saugseite relativ zum Flanschabschnitt erfolgt vorzugsweise senkrecht zur flächigen Erstreckung des Flanschabschnitts.

Wie bereits erwähnt, ist vorteilhaft, wenn der Batteriegreifer Prüf- und/oder Messeinheiten zur Prüfung und/oder Messung der Batteriezellen aufweist. Die einzelnen Prüf- und/oder Messeinheiten können dabei vorzugsweise flanschseitig angeordnet sein, so dass diese erst beim Verlagern der Batteriezelle aus der Greifposition in die Messposition zur Anwendung kommen. Solche Prüf- und/oder Messeinheiten können beispielsweise Barcodesensoren, Datamatrixcodesensoren, RFID-Sensoren, Temperatursensoren, Längenmesseinheiten, Bauchigkeitsmesseinheiten, Lichttaster, Batterieprüfeinheiten oder dergleichen sein.

Ferner ist vorteilhaft, wenn beim Ansaugen der Batteriezelle beim Greifvorgang Zentriermittel vorgesehen sind, mittels welchen die Batteriezelle in eine definiert vorgegebene Greifposition gebracht wird. Dadurch wird gewährleistet, dass eine spätere Prüfung und/oder Messung der Batteriezelle in einer definierten Position ermöglicht wird. Die Zentriermittel können beispielsweise als Einführschrägen oder Zentrierpins ausgebildet sein.

Vorteilhafterweise ist eine Kontaktierungseinheit mit wenigstens einem relativ zur Saugseite verlagerbaren Prüfkontakt zur Kontaktierung von wenigstens einem Batteriepol vorgesehen. Insbesondere dann, wenn sich die Batteriezelle in der Messposition befindet, kann vorgesehen sein, dass der Prüfkontakt aus einer Grundposition in eine Kontaktposition verlagert wird, wodurch dann die Batterie auf ihre elektrischen Eigenschaften hin geprüft werden kann. Der Prüfkontakt kann dabei beispielsweise an einem Schwenkarm oder an einem linear verfahrbaren Arm angeordnet sein und elektrische Leitungen aufweisen, die zu einer entsprechenden Batterieprüfeinheit führen.

Ferner ist vorteilhaft, wenn eine Längenmesseinheit mit wenigstens einem relativ zur Saugseite verlagerbaren Anschlag zur Anlage an die dem Batteriepol gegenüberliegende Seite der Batteriezelle vorgesehen ist, wobei über den Abstand eines mit dem Prüfkontakt bewegungsgekoppelten ersten Gliedes und eines mit dem Anschlag bewegungsgekoppelten zweiten Gliedes auf die Länge der Batteriezelle rückgeschlossen werden kann. Folglich werden hierbei der Prüfkontakt einerseits gegen die Batteriezelle beaufschlagt und der Anschlag andererseits gegen die gegenüberliegende Seite der Batteriezelle beaufschlagt. Über den Abstand zwischen Prüfkontakt und Anschlag bzw. über den Abstand zwischen erstem Glied und zweitem Glied kann folglich die Länge der Batteriezelle bestimmt werden.

Der Anschlag kann beispielsweise an einem Anschlagarm vorgesehen sein, der flanschseitig schwenkbar oder linear verfahrbar flanschabschnittseitig angebracht ist.

Zur Längenmessung des Abstandes zwischen insbesondere dem ersten und dem zweiten Glied kann das erste bzw. zweite Glied eine Reflexionsfläche aufweisen und das zweite bzw. erste Glied einen Lichttaster. Damit kann berührungslos der jeweilige Abstand und damit auch die Größe der Batteriezelle berührungslos vergleichsweise genau gemessen werden.

Gemäß einer Ausgestaltung der Erfindung weist der Batteriegreifer ein Grundteil auf, welches den Flanschabschnitt umfasst. Ferner ist ein Basisteil vorgesehen, welches die Saugeinheit umfasst. Das Basisteil ist dabei vorzugsweise am Grundteil gleitend geführt gelagert, so dass das Basisteil samt Saugseite zwischen der Greifposition und der Messposition verlagerbar ist. Die gleitende Führung kann beispielsweise als Schienen- oder Stangenführung realisiert sein.

Vorteilhafterweise können einzelne und/oder alle Prüf- und/oder Messeinheiten, die Kontaktierungseinheit und/oder die Längenmesseinheit am Grundteil angeordnet sein. Dies hat den Vorteil, dass diese Einheiten dann bei Verlagerung der Saugseite nicht bewegt werden. Ferner ist vorteilhaft, wenn Anschlüsse, wie beispielsweise elektrische oder pneumatische Anschlüsse, welche diese Einheiten versorgen, flanschseitig angeordnet sind.

Dabei ist denkbar, dass die Prüf- und/oder Messeinheiten optische Sensoren umfassen, wobei Spiegel vorgesehen sind, die den Erfassungsbereich der Sensoren hin zur Batteriezelle umlenken.

Die eingangs genannte Aufgabe wird auch gelöst durch ein Verfahren mit den Merkmalen des Anspruchs 10. Das Verfahren sieht folglich vor, dass die Batteriezellen zunächst gegriffen werden, dass die Batteriezellen nach dem Greifen aus der Greifposition in die Messposition verlagert werden, und dass Prüfungen und/oder Messungen an der Batteriezelle in der Messposition erfolgen. Besonders vorteilhaft ist, wenn die Prüfungen und/oder Messungen an der Batteriezelle während des Verlagerns oder Handhabens der Batteriezelle erfolgen.

Die eingangs genannte Aufgabe wird auch gelöst durch die Verwendung eines erfindungsgemäßen Greifers zur Durchführung des erfindungsgemäßen Verfahrens.

Weitere Einzelheiten und vorteilhafte Ausgestaltungen der Erfindung sind der nachfolgenden Beschreibung zu entnehmen, anhand derer ein Ausführungsbeispiel der Erfindung näher beschrieben und erläutert ist.

Es zeigen:
- Figur 1: einen erfindungsgemäßen Batteriegreifer in perspektivischer Ansicht von schräg oben;
- Figur 2: den Batteriegreifer nach Figur 1 in Ansicht von schräg vorne;
- Figur 3: einen Längsschnitt durch den Batteriegreifer gemäß Figur 1;
- Figur 4: einen Querschnitt durch den Batteriegreifer gemäß Figur 1;
- Figur 5: den Batteriegreifer gemäß Figur 1 in Seitenansicht vor dem Greifen;
- Figur 6: den Batteriegreifer gemäß Figur 5 in Greifposition;
- Figur 7: den Batteriegreifer gemäß Figur 5 in Messposition; und
- Figur 8: den Batteriegreifer gemäß Figur 5 mit kontaktiertem Prüfkontakt und mit angeschlagenem Anschlag.

In den Figuren ist ein Batteriegreifer 10 zum Greifen und Verlagern von einzelnen Batteriezellen 30 dargestellt. Der Batteriegreifer 10 umfasst einen Flanschabschnitt 12 zur Anordnung des Batteriegreifers 10 an einen Roboterarm. Mit dem Roboterarm kann der Batteriegreifer 10 vorzugsweise frei im Raum verlagert werden. Der Flanschabschnitt 12 sieht dazu einen Befestigungsabschnitt 14 mit Bohrungen vor, welche zur Befestigung des Batteriegreifers 10 am Roboterarm dienen. Ferner sind am Flanschabschnitt 12 elektrische Anschlüsse 16 sowie pneumatische Anschlüsse 18 vorgesehen. Die elektrischen Anschlüsse 16 dienen zur Versorgung von an dem Batteriegreifer 10 vorgesehenen Prüf- und Messeinheiten. Die pneumatischen Anschlüsse dienen zur Versorgung von am Batteriegreifer 10 vorgesehenen Hubeinrichtungen.

Der Batteriegreifer 10 umfasst ein Grundteil 20, wobei das Grundteil 20 den Flanschabschnitt 12 umfasst. Am Grundteil 20 ist ein gegenüber dem Grundteil 20 verlagerbares Basisteil 22 vorgesehen, wobei das Basisteil 22 über Führungsabschnitte 24 am Grundteil gleitend gelagert angeordnet ist. Das Grundteil 20 weist zudem eine Grundteilplatte 21 auf, die über Stützleisten 23 starr mit dem Flanschabschnitt 12 verbunden sind.

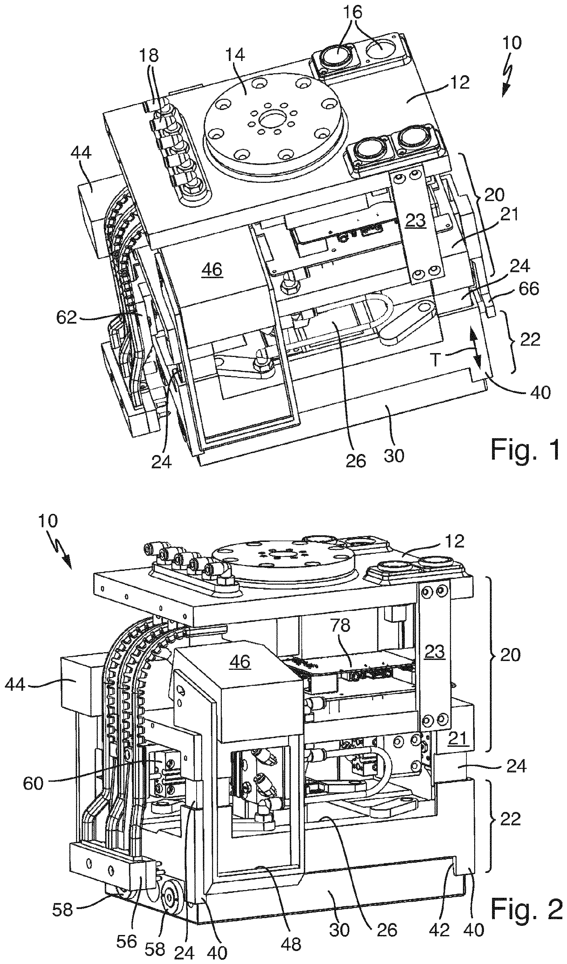

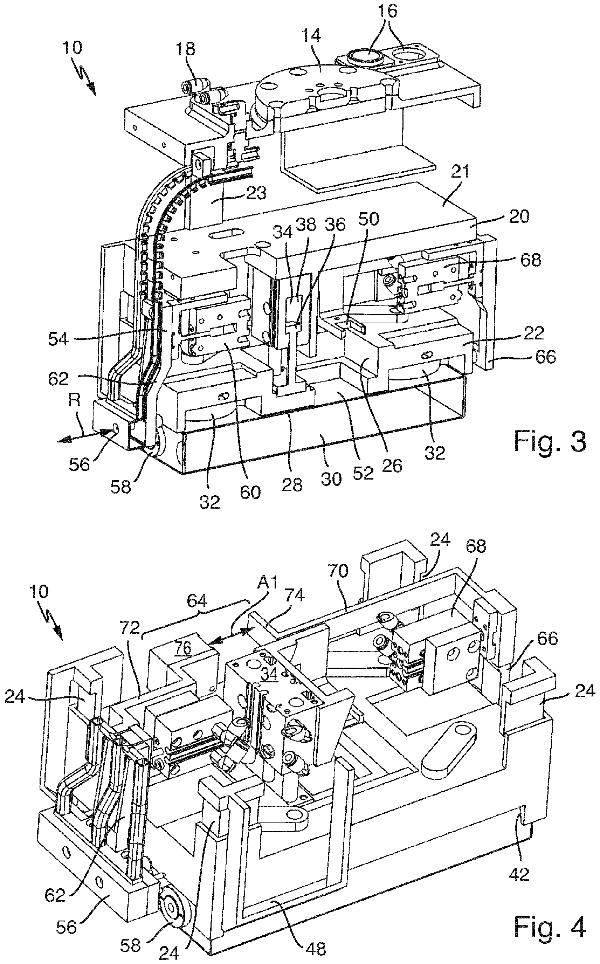

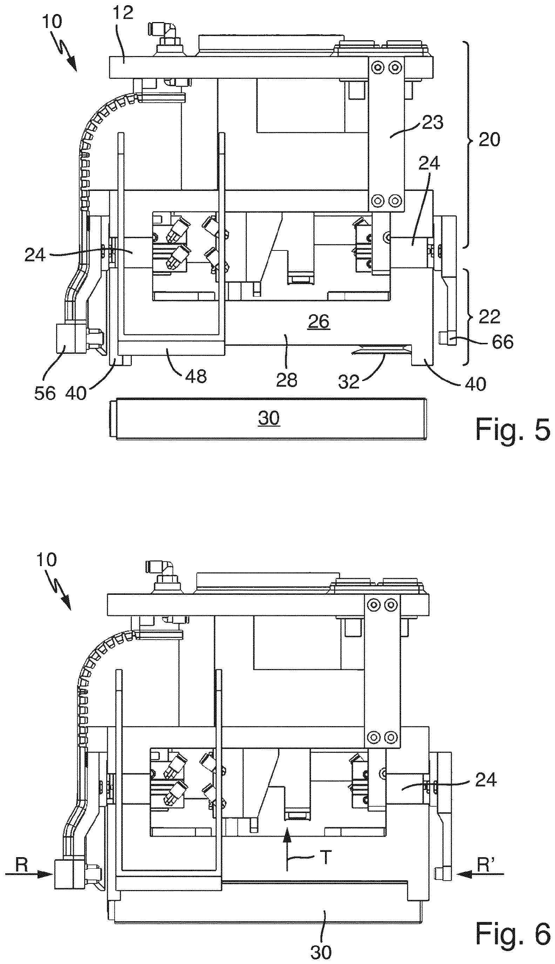

Am Basisteil 22 ist eine Saugeinheit 26 mit einer Saugseite 28 vorgesehen, wobei die in Figur 1 und 2 gegriffene Batteriezelle 30 durch Ansaugen der Batteriezelle 30 durch die Saugseite 28 gegriffen wird. Wie aus dem Schnitt gemäß Figur 3 und auch aus Figur 5 deutlich wird, weist die Saugseite 28 Saugbalge 32 auf.

Wie ferner aus dem Schnitt gemäß Figur 3 deutlich wird, ist zwischen dem Grundteil 20 und dem Basisteil 22 eine Hebevorrichtung 34 vorgesehen, mittels welcher die Saugseite 28 relativ zum Flanschabschnitt 12 bzw. zum Grundteil 20 verlagerbar ist. Bei der Ausführungsform gemäß Figur 3 ist die Hebevorrichtung 34 als doppelseitig druckbeaufschlagbare Kolben-Zylinder-Einheit ausgebildet.

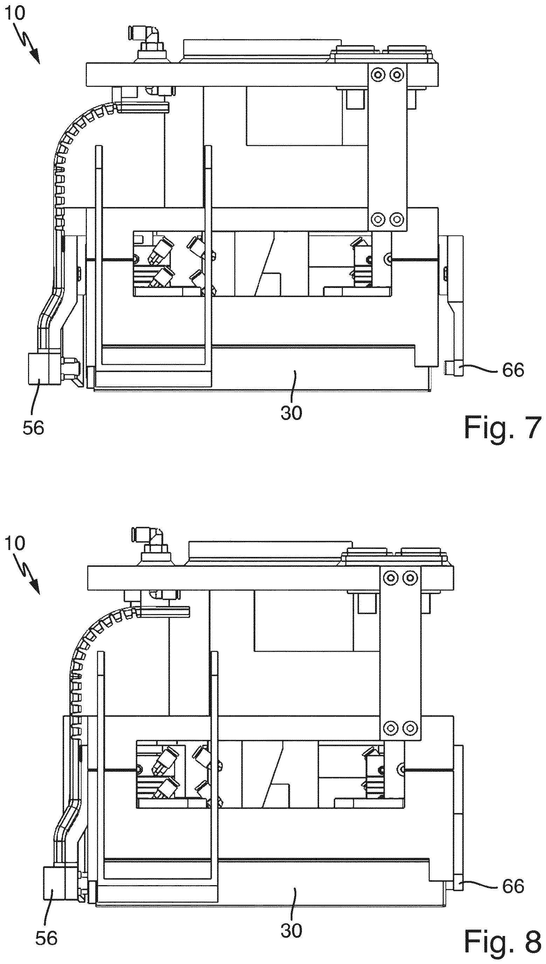

Je nach Druckbeaufschlagung des Kolbens 36 wird dieser im Zylinder 38 hin zum Flanschabschnitt 12 bzw. weg vom Flanschabschnitt 12 bewegt. Aufgrund der Führungsabschnitte 24 wird dadurch das Basisteil 22 bzw. die Saugseite 28 aus der in den Figuren 1 bis 4 und 6 gezeigten Greifposition, in der die Batteriezelle 30 gegriffen wird, in die in Figur 7 und 8 gezeigte Messposition verlagert.

Der in den Figuren gezeigte Batteriegreifer 10 zeichnet sich folglich dadurch aus, dass die Saugseite 28 durch die Hebevorrichtung 34 aus der Greifposition, in der die Batteriezelle 30 gegriffen wird, relativ zum Flanschabschnitt 12 in die Messposition verlagerbar ist, in der Prüfungen und/oder Messungen der Batteriezelle 30 durchgeführt werden können. Die Verlagerung erfolgt dabei in einer senkrecht zur Saugseite verlaufenden Richtung T.

Um zu gewährleisten, dass beim Greifen bzw. Ansaugen der Batteriezelle 30 diese eine vordefinierte Position einnimmt, sind an der Saugseite 28, bzw. die Saugseite 28 umgebend, Zentriermittel 40 vorgesehen. Die Zentriermittel 40 sind als abragende Stege ausgebildet, die Führungsschrägen 42 aufweisen, so dass beim Ansaugen der Batteriezelle 30 diese eine vordefinierte Lage einnimmt. Anstelle von Führungsschrägen 42 ist auch denkbar, Zentrierpins und/oder zugehörige Zentrierausnehmungen vorzusehen.

Am Grundteil 20 sind verschiedene Prüf- und Messeinheiten zur Durchführung von Prüfungen und Messungen der Batteriezelle 30 in der Messposition vorgesehen. In den Figuren 1 und 2 sind zwei optische Sensoren 44 und 46 gezeigt, beispielsweise zur Erkennung von Datamatrixcodes oder Barcodes. Der Erfassungsbereich dieser optischen Sensoren wird über an schräg zur Ebene der Saugseite 28 verlaufende Spiegel 48 hin zur Batteriezelle 30 umgelenkt, so dass mit diesen Sensoren 44, 46 auf der Batteriezelle 30 vorhandene Codes abgetastet werden können.

Am Grundteil 20 kann ferner ein an dem in Figur 3 gezeigten Halteabschnitt 50 vorzusehender Temperatursensor vorgesehen sein, der durch eine am Basisteil 22 vorgesehene Aussparung 52 die Oberflächentemperatur der gegriffenen Batteriezelle 30 misst. Im Bereich des Halteabschnitts 50 kann ferner ein in den Figuren nicht dargestellter Lichttaster vorgesehen sein, der ebenfalls durch die Aussparung 52 die Konvexität, also die Bauchigkeit, der gegriffenen Batteriezelle 30 erfasst.

Zur Prüfung der elektrischen Eigenschaften der Batteriezelle 30 ist eine Kontaktierungseinheit 54 vorgesehen, die einen parallel zur Längserstreckung des Flanschabschnitts 12 verlagerbaren Prüfkontakt 56 zur Kontaktierung von Batteriepolen 58 aufweist. Die Kontaktierungseinheit 56 umfasst dabei eine in Figur 3 deutlich zu erkennende Hubeinheit 60, welche über einen Kontaktarm 62 mit dem Prüfkontakt 56 bewegungsgekoppelt ist. Die Hubeinheit 60, die gemäß dem dargestellten Ausführungsbeispiel als Kolben-Zylinder-Einheit ausgebildet ist, bewegt folglich den Prüfkontakt 56 in einer parallel zur Saugseite verlaufenden Richtung R aus einer batteriefernen Grundposition in eine am Batteriepol 58 anliegende Kontaktposition. In der Kontaktposition können folglich die elektrischen Werte der Batteriezelle 30 ausgelesen werden.

Zur Längenmessung der Batteriezelle 30 ist eine Längenmesseinheit 64 vorgesehen, die insbesondere in Figur 4 deutlich zu erkennen ist. Die Längenmesseinheit 64 umfasst einen relativ zur Saugseite 28 verlagerbaren Anschlag 66 zur Anlage an die dem Batteriepol 58 abgewandten Seite der Batteriezelle 30. Zur Verlagerung des Anschlags 66 ist eine der Hubeinheit 60 entsprechende Hubeinheit 68 vorgesehen, wobei die Verlagerung des Anschlags 66 in einer der Richtung R gegenläufigen Richtung R' erfolgt. Die Batteriezelle 30 ist folglich zwischen dem Prüfkontakt 58 und dem Anschlag 66 einklemmbar.

Der Anschlag 66 ist dabei mit einem ersten Glied 70 bewegungsgekoppelt. Der Prüfkontakt 56 ist seinerseits mit einem zweiten Glied 72 bewegungsgekoppelt. Das erste Glied 70 weist an seinem freien Ende einen Reflexionsabschnitt 74 auf. Das zweite Glied 72 weist an seinem den Reflexionsabschnitt 74 zugewandten Ende einen Lichttaster 76 auf, mit dem der Abstand A zwischen dem Reflexionsabschnitt 74 und dem Lichttaster 76 bestimmbar ist. Über den Abstand A kann dann auf die Länge der Batteriezelle 30 rückgeschlossen werden.

Zur Auswertung der von den optischen Sensoren 44, 76, dem Temperatursensor, dem Lichttaster zur Messung der Konvexität, der Längenmesseinheit 64 und der über die Kontaktierungseinheit 54 gemessenen elektrischen Signale ist eine Auswerteeinheit 78 zwischen dem Flanschabschnitt 12 und der Grundplatte 21 vorgesehen. Die von der Auswerteeinheit 78 erfassten Daten können über die Anschlüsse 16 und/oder über Funk an eine übergeordnete Kontroll- oder Steuereinheit weitergegeben werden.

In den Figuren 5 bis 8 wird nachfolgend das Verfahren zum Greifen und Verlagern der Batteriezellen 30 mit dem Batteriegreifer 10 beschrieben. Die Figur 5 zeigt den Greifer 10 kurz vor dem Greifen der Batteriezelle 30. Der Greifer 10 wird über einen nicht dargestellten Roboterarm auf die Batteriezelle 30 aufgesetzt. Aufgrund der Zentriermittel 40 nimmt die Batteriezelle 30 eine definierte Lage an dem Batteriegreifer 10 ein. Nachdem der Batteriegreifer 10 auf die Batteriezelle 30 aufgesetzt ist, wird die Batteriezelle 30 von der Saugeinheit 26 an der Saugseite 28 über die Saugbalge 32 angesaugt, wie in Figur 6 dargestellt. Durch Anheben des Batteriegreifers 10 mittels des Roboterarms kann folglich die Batteriezelle 30 verlagert werden. Während des Verlagerns der Batteriezelle 30 kann dann, wie in Figur 7 gezeigt, das Basisteil 22 über die Hebevorrichtung 34 in Richtung T aus der Greifposition in die in Figur 7 gezeigte Messposition verlagert werden. In dieser Messposition können dann insbesondere zeitgleich verschiedene Prüfungen und Messungen an der Batteriezelle vorgenommen werden. Zur Prüfung der elektrischen Eigenschaft der Batterie der Batteriezelle 30 und zur Längenmessung der Batteriezelle 30 wird dann der Prüfkontakt 56 in Richtung R gegen die Batteriepole 58 gefahren und der Anschlag 66 wird in Richtung R' gegen die der Batteriepole 58 gegenüberliegende Seite der Batteriezelle 30 gefahren, wie in Figur 8 dargestellt.

Vorteilhafterweise werden die einzelnen Messungen an der Batteriezelle 30 während des Verlagerns der Batteriezelle 30 durchgeführt. Nach erfolgter Messung kann die Batteriezelle 30 dann an einem vorgegebenen Ort abgesetzt werden, beispielsweise an einer Montagestation, an der Batteriepacks gebildet werden, die aus mehreren, einzelnen Batteriezellen 30 zusammengesetzt sind.

## Patentansprüche

1. Batteriegreifer (10), zum Greifen und Verlagern von einzelnen Batteriezellen (30), mit einem Flanschabschnitt (12) zur Anordnung des Batteriegreifers (10) an einen Roboterarm und mit einer eine Saugseite (28) aufweisenden Saugeinheit (26) zum Greifen der Batteriezelle (30), **dadurch gekennzeichnet, dass** eine Hebevorrichtung (34) vorgesehen ist, mit der im Betrieb des Batteriegreifers (10) die Saugseite (28) aus einer Greifposition, in der die Batteriezelle (30) gegriffen wird, relativ zum Flanschabschnitt (12) in eine Messposition verlagerbar ist, in der Prüfungen und/oder Messungen an der gegriffenen Batteriezelle (30) durchführbar sind.

2. Batteriegreifer (10) nach Anspruch 1, **dadurch gekennzeichnet, dass** Zentriermittel (40) vorgesehen sind, durch welche beim Greifen der Batteriezelle (30) die Batteriezelle (30) in eine definierte Greiflage an der Saugseite (28) gebracht wird.

3. Batteriegreifer (10) nach Anspruch 1 oder 2, **dadurch gekennzeichnet, dass** der Batteriegreifer (10) Prüf- und/oder Messeinheiten zur Durchführung von Prüfungen und/oder Messungen der Batteriezelle (30) aufweist.

4. Batteriegreifer (10) nach Anspruch 1, 2 oder 3, **dadurch gekennzeichnet, dass** eine Kontaktierungseinheit (54) mit wenigstens einem relativ zur Saugseite (28) verlagerbaren Prüfkontakt (56) zur Kontaktierung von wenigstens einem Batteriepol (58) vorgesehen ist.

5. Batteriegreifer (10) nach Anspruch 4, **dadurch gekennzeichnet, dass** eine Längenmesseinheit (64) mit wenigstens einem relativ zur Saugseite (28) verlagerbaren Anschlag (66) zur Anlage an die dem Batteriepol (58) gegenüberliegende Seite der Batteriezelle (30) vorgesehen ist, wobei über den Abstand eines mit Prüfkontakt (56) bewegungsgekoppelten ersten Gliedes (72) und eines mit dem Anschlag (66) bewegungsgekoppelten zweiten Gliedes (70) auf die Länge der Batteriezelle rückgeschlossen wird.

6. Batteriegreifer (10) nach Anspruch 5, **dadurch gekennzeichnet, dass** das erste bzw. das zweite Glied (70, 72) eine Reflexionsfläche (74) aufweist und dass das zweite bzw. das erste Glied einen Lichttaster (76) zur Entfernungsmessung aufweist.

7. Batteriegreifer (10) nach einem der vorhergehenden Ansprüche, **dadurch gekennzeichnet, dass** ein Grundteil (20) vorgesehen ist, welches den Flanschabschnitt (12) umfasst, und dass ein Basisteil (22) vorgesehen ist, welches die Saugeinheit (26) umfasst, wobei das Basisteil (22) am Grundteil (20) zur Verlagerung gleitend geführt angeordnet ist.

8. Batteriegreifer (10) nach Anspruch 7
**dadurch gekennzeichnet, dass** die Prüf- und oder Messeinheiten, die Kontaktierungseinheit (54) und/oder die Längenmesseinheit (64) am Grundteil angeordnet sind.

9. Batteriegreifer (10) nach einem der vorhergehenden Ansprüche, **dadurch gekennzeichnet, dass** die Prüf- und/oder Messeinheiten optische Sensoren (44, 46) umfassen, deren Erfassungsbereich über Spiegel (48) hin zur Batteriezelle umgelenkt werden.

10. Verfahren zum Greifen und Verlagern von einzelnen Batteriezellen (30), mit den folgenden Schritten:
a. Greifen der Batteriezelle mit einem an einem Roboterarm angeordneten Batteriegreifer (10),
b. Verlagern der gegriffenen Batteriezelle (30) an dem Batteriegreifer (10) aus einer Greifposition in eine Messposition, **gekennzeichnet durch** den folgenden Schritt:
c. Durchführen von Prüfungen und/oder Messungen an der Batteriezelle (30) in der Messposition während des Verlagerns der Batteriezelle (30).

11. Verwendung eines Batteriegreifers (10) nach wenigstens einem der Ansprüche 1 bis 9 zur Durchführung des Verfahrens nach Anspruch 10.

## Claims

1. A battery gripper (10) for gripping and displacing individual battery cells (30), with a flanged portion (12) for arranging the battery gripper (10) on a robot arm and with a suction unit (26) having a suction side (28) for gripping the battery cell (30), **characterized in that** a lifting device (34) is provided with which, during operation of the battery gripper (10), the suction side (28) can be displaced relative to the flanged portion (12) from a gripping position in which the battery cell (30) is gripped to a measuring position in which tests and/or measurements can be carried out on the gripped battery cell (30).

2. The battery gripper (10) according to claim 1, **characterized in that** centering means (40) are provided by means of which the battery cell (30) is brought into a defined gripping position on the suction side (28) when the battery cell (30) is being gripped.

3. The battery gripper (10) according to claim 1 or 2, **characterized in that** the battery gripper (10) has testing and/or measuring units for carrying out tests and/or measurements on the battery cell (30).

4. The battery gripper (10) according to claim 1, 2, or 3, **characterized in that** a contacting unit (54) is provided with at least one test contact (56) that can be displaced relative to the suction side (28) for the purpose of contacting at least one battery pole (58).

5. The battery gripper (10) according to claim 4, **characterized in that** a length measuring unit (64) is provided with at least one stop (66) that can be displaced relative to the suction side (28) in order to contact the side of the battery cell (30) opposite the battery pole (58), the length of the battery cell being inferred from the distance between a first member (72) that is motion-coupled to the test contact (56) and a second member (70) that is motion-coupled to the stop (66).

6. The battery gripper (10) according to claim 5, **characterized in that** the first and/or the second member (70, 72) has a reflective surface (74), and **in that** the second or the first member has a light scanner (76) for measuring distance.

7. The battery gripper (10) according to one of the preceding claims, **characterized in that** a base part (20) is provided that comprises the flanged portion (12), and **in that** a base part (22) is provided that comprises the suction unit (26), the base part (22) being slidingly guided on the base part (20) for displacement.

8. The battery gripper (10) according to claim 7, **characterized in that** the testing and/or measuring units, the contacting unit (54), and/or the length measuring unit (64) are arranged on the base part.

9. The battery gripper (10) according to one of the preceding claims, **characterized in that** the testing and/or measuring units comprise optical sensors (44, 46) whose detection areas are deflected toward the battery cell by means of mirrors (48).

10. A method for gripping and displacing individual battery cells (30), with the following steps:
a. gripping the battery cell with a battery gripper (10) arranged on a robot arm,
b. displacing the gripped battery cell (30) on the battery gripper (10) from a gripping position to a measuring position, **characterized by the following step:**
c. carrying out tests and/or measurements on the battery cell (30) in the measuring position during the displacement of the battery cell (30).

11. A use of a battery gripper (10) according to at least one of claims 1 to 9 for carrying out the method according to claim 10.

## Revendications

1. Dispositif de préhension de batteries (10) permettant de saisir et de déplacer des éléments de batterie (30) individuels, le dispositif comportant une partie formant bride (12) pour disposer le dispositif de préhension de batteries (10) sur un bras robotisé, et comportant une unité d'aspiration (28) présentant un côté d'aspiration (26) pour saisir les éléments de batterie (30), **caractérisé en ce qu'**il est prévu un dispositif de levage (34) au moyen duquel, lors du fonctionnement du dispositif de préhension de batteries (10), le côté d'aspiration (28) peut être déplacé d'une position de préhension, dans laquelle l'élément de batterie (30) est saisi, par rapport à la partie formant bride (12), à une position de mesure, dans laquelle il est possible d'effectuer des vérifications et/ou des mesures sur l'élément de batterie (30) saisi.

2. Dispositif de préhension de batteries (10) selon la revendication 1, **caractérisé en ce que** des moyens de centrage (40) sont prévus, au moyen desquels, lorsque les éléments de batterie (30) sont saisis, ceux-ci sont mis dans une position de préhension définie sur le côté d'aspiration (28).

3. Dispositif de préhension de batteries (10) selon la revendication 1 ou 2, **caractérisé en ce que** le dispositif de préhension de batteries (10) présente des unités de vérification et/ou de mesure permettant d'effectuer des vérifications et/ou des mesures sur l'élément de batterie (30).

4. Dispositif de préhension de batteries (10) selon la revendication 1, 2 ou 3, **caractérisé en ce qu'**il est prévu une unité de mise en contact (54) comportant au moins un contact de vérification (56) monté par rapport au côté d'aspiration (28) pour venir en contact avec au moins une borne de batterie (58).

5. Dispositif de préhension de batteries (10) selon la revendication 4, **caractérisé en ce qu'**il est prévu une unité de mesure de longueur (64) comportant au moins une butée (66) montée par rapport au côté d'aspiration (28) de façon à être appliquée contre le côté de l'élément de batterie (30) qui est opposé à la borne de batterie (58), la longueur de l'élément de batterie étant déduite par l'espacement entre un premier maillon (72) couplé cinématiquement au contact de vérification (56) et un second maillon (70) couplé cinématiquement à la butée (66).

6. Dispositif de préhension de batteries (10) selon la revendication 5, **caractérisé en ce que** le premier ou le second maillon (70, 72) présente une surface réfléchissante (74), et **en ce que** le second ou le premier maillon présente un détecteur de lumière (76) permettant de mesurer des distances.

7. Dispositif de préhension de batteries (10) selon l'une des revendications précédentes, **caractérisé en ce qu'**il est prévu une pièce de base (20) comprenant une partie formant bride (12), et **en ce qu'**il est prévu une pièce socle (22) comprenant l'unité d'aspiration (26), la pièce socle (22) étant disposée de manière à être guidée de façon coulissante sur la pièce de base (20) afin d'être déplacée.

8. Dispositif de préhension de batteries (10) selon la revendication 7, **caractérisé en ce que** les unités de vérification et/ou de mesure, les unités de mise en contact (54) et/ou les unités de mesure de longueur (64) sont disposées sur la pièce de base.

9. Dispositif de préhension de batteries (10) selon l'une des revendications précédentes, **caractérisé en ce que** les unités de vérification et de mesure comprennent des capteurs optiques (44, 46) dont la portée est réorientée vers l'élément de batterie par l'intermédiaire d'un miroir (48).

10. Procédé de préhension et de déplacement d'éléments de batterie (30) individuels, le procédé comprenant les étapes suivantes :
a. saisie de l'élément de batterie au moyen d'un dispositif de préhension de batteries (10) disposé sur un bras robotisé,
b. déplacement de l'élément de batterie (30) saisi par le dispositif de préhension de batteries (10), d'une position de préhension à une position de mesure, **caractérisé par l'étape suivante** :
c. réalisation de vérifications et/ou de mesures sur l'élément de batterie (30) dans la position de mesure pendant le déplacement de l'élément de batterie (30).

11. Utilisation d'un dispositif de préhension de batteries (10) selon au moins l'une des revendications 1 à 9, pour la mise en œuvre du procédé selon la revendication 10.
